Europäisches Patentamt

European Patent Office

Office européen des brevets

(19)

(11) EP 0 830 717 B1

(12) EUROPÄISCHE PATENTSCHRIFT

(45) Veröffentlichungstag und Bekanntmachung des Hinweises auf die Patenterteilung:
14.10.1998 Patentblatt 1998/42

(21) Anmeldenummer: 96919625.2

(22) Anmeldetag: 03.06.1996

(51) Int Cl.⁶: H01S 3/085

(86) Internationale Anmeldenummer:
PCT/DE96/00975

(87) Internationale Veröffentlichungsnummer:
WO 96/42130 (27.12.1996 Gazette 1996/56)

(54) **OBERFLÄCHENEMITTIERENDE LASERDIODE**

SURFACE EMITTING LASER DIODE

DIODE LASER A EMISSION PAR LA SURFACE

(84) Benannte Vertragsstaaten:
DE FR GB

(30) Priorität: 08.06.1995 DE 19520998

(43) Veröffentlichungstag der Anmeldung:
25.03.1998 Patentblatt 1998/13

(73) Patentinhaber: SIEMENS
AKTIENGESELLSCHAFT
80333 München (DE)

(72) Erfinder: BITTNAR, Jutta
D-81541 München (DE)

(56) Entgegenhaltungen:
US-A- 4 633 476          US-A- 5 373 173

• IBM TECHNICAL DISCLOSURE BULLETIN, Bd. 32, Nr. 3B, August 1989, Seite 498/499 XP000029770 "VERTICALLY EMITTING LASER WITH INTEGRATED NON-ABSORBING MIRROR DEFLECTOR"
• IBM TECHNICAL DISCLOSURE BULLETIN, Bd. 32, Nr. 12, 1.Mai 1990, Seiten 19-21, XP000105055 "IMPROVED NORMAL-EMISSION REFLECTOR FOR STRIPE LASERS USING SUBLIME TECHNOLOGY"
• GALLIUM ARSENIDE AND RELATED COMPOUNDS, KARUIZAWA, SEPT. 28 - OCT. 2, 1992, Nr. SYMP. 19, 28.September 1992, IKEGAMI T;HASEGAWA F; TAKEDA Y, Seiten 797-802, XP000366297 TOYOHARU OHATA ET AL: "SURFACE-EMITTING LASER DIODES EMPLOYING GROWN-IN 45 MIRRORS"

**Beschreibung**

Die vorliegende Erfindung betrifft eine oberflachenemittierende Laserdiode in III-V-Halbleitermaterial.

Die Verfügbarkeit von Spiegeln in Halbleitermaterial, die in einem Winkel von 45° zur Schichtebene der Struktur der Laserdiode geneigt sind, ermöglicht es, oberflächenemittierende Laserdioden zu realisieren, die mit einer strahlungserzeugenden Struktur mit einem Resonator, wie er für kantenemittierende Laser vorgesehen ist, versehen sind. Die Emission der Strahlung senkrecht zu der Oberfläche wird dadurch erreicht, daß ein solcher Spiegel das an den Kanten des Resonators emittierte Licht um 90° senkrecht zur Schichtebene reflektiert. Ein dabei auftretendes Problem besteht darin, daß die verwendeten Spiegel sehr genau den Winkel von 45° zur Schichtebene aufweisen müssen und sehr eben mit geringster fertigungstechnischer Toleranz hergestellt sein müssen.

Bisher wendete man das Verfahren des Ionenstrahlatzens (IBE oder RIBE) zur Herstellung solcher Spiegelflächen an. Mit einer Maske aus $Al_2O_3$ und durch Schrägstellen des zu bearbeitenden Substrates zum Stickstoff-Ionenstrahl wird eine um 45° geneigte Flanke in dem Halbleitermaterial mit einer erforderlichen Tiefe von 4 $\mu m$ geätzt. Der Nachteil dieses Verfahrens liegt in einer relativ großen Ungenauigkeit des damit hergestellten Winkels und in einer relativ großen Rauhigkeit der hergestellten Spiegelfläche, die außerdem von der Qualität der Ränder der Maske abhängig ist. Eine rein naßchemische Strukturierung der Spiegelflächen ist wegen der vorhandenen mehrlagigen (Hetero-)Schicht, in denen die Ätzangriffe in verschiedenen Schichten unterschiedlich stark ausfallen, nicht praktikabel.

Aus der DE 26 22 267 A1 ist eine Injektionslaser-Matrix mit einem pn-Übergang bekannt, bei der die in den Halbleiterkörper geätzten V-förmigen Ausnehmungen durch Flächen begrenzt werden, die mit der Ebene des pn-Übergangs einen Winkel von genau 45° bilden und an denen die parallel zur Ebene des pn-Übergangs entstehende Strahlung senkrecht abgelenkt wird. Die Winkellagen dieser Flächen sind durch den Ätzvorgang und durch die Zinkblendestruktur der verwendeten Halbleiter mit größter Genauigkeit definiert. In der US 5,253,263 ist eine oberflächenemittierende Halbleiterlaserdiode beschrieben, bei der ein um 45° geneigter Spiegel in den Strahlengang integriert ist. Dieser geneigte Spiegel befindet sich im Innern des als Resonator vorgesehenen Bereiches. In der US 4,760,578 ist ein Halbleiterlaser beschrieben, bei dem die in einer aktiven Schicht erzeugte Strahlung an Endflächen des Resonators reflektiert werden und diese Endflächen zur Schichtebene um 45° geneigt sind, so daß die Strahlung zum Substrat hin auf eine zur Modulation vorgesehene Schicht und auf eine zur Reflexion der Strahlung vorgesehene Schicht reflektiert wird. In der US 4,633,476 ist ein Halbleiterlaser beschrieben, bei dem die Resonatorendflächen um 45° geneigt sind, so daß die erzeugte Strahlung zum Substrat hin reflektiert und durch Öffnungen im Substrat emittiert wird. Es ist parallel zur aktiven Schicht ein DFB-Gitter vorhanden.

Aufgabe der vorliegenden Erfindung ist es, eine verbesserte oberflächenemittierende Laserdiode in III-V-Material, die einfach herstellbar ist, anzugeben.

Diese Aufgabe wird mit der Laserdiode mit den Merkmalen des Anspruches 1 gelöst. Weitere Ausgestaltungen ergeben sich aus den abhängigen Ansprüchen.

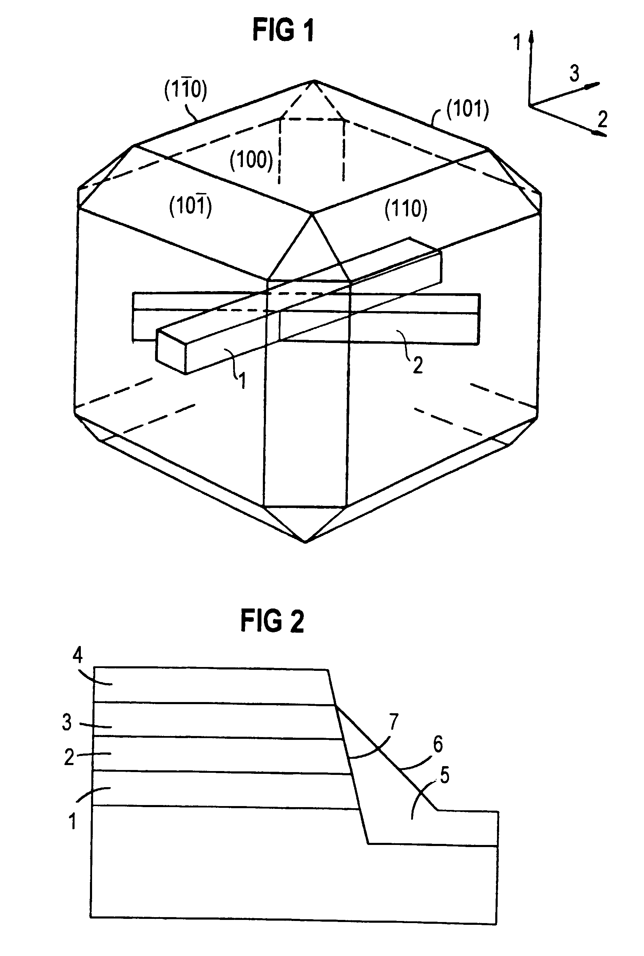

Die erfindungsgemäße Laserdiode benutzt die Eigenschaft des III-V-Halbleitermateriales, als Kristallstruktur ein Zinkblendegitter zu haben. In diesem Kristallgitter sind die Gitterebenen entsprechend der beigefügten Figur 1 ausgerichtet, so daß z. B. die mit den Miller-Indizes bezeichneten Ebenen (110) und (101) einen Winkel von 45° zu der Ebene (100) bilden. Die Kristallebenen lassen sich naßchemisch bei geeigneter Wahl der Ätzlösung in homogenem kristallinem Halbleitermaterial herstellen.

Die erfindungsgemäße Laserdiode verfügt über eine streifenförmige aktive Zone in einer aktiven Schicht aus einem für Strahlungserzeugung vorgesehenen Halbleitermaterial. Diese aktive Schicht kann z. B. streifenförmig ausgebildet sein und die aktive Zone bilden. Es ist auch möglich, durch geeignete Wahl z. B. der für Strominjektion vorgesehenen Kontakte die Strahlungserzeugung in einer ganzflächigen Schicht auf eine derartige streifenförmige aktive Zone zu begrenzen. In Längsrichtung dieser aktiven Zone ist ein Laserresonator gebildet, z. B. indem an den Enden Spiegelendflächen, die die Strahlung reflektieren, vorhanden sind. Alternativ oder zusätzlich dazu können, wie bei Laserdioden sonst auch üblich, DFB-Gitter oder DBR-Gitter verwendet werden. Die aktive Zone bzw. der die aktive Zone enthaltende Anteil der aktiven Schicht ist in III-V-Halbleitermaterial mit Zinkblendestruktur so eingebettet, daß die Längsrichtung der aktiven Zone entsprechend dem schematisch in Figur 1 eingezeichneten Balken 1 senkrecht zur Kristallebene mit den Miller-Indizes (001) ausgerichtet ist. In dem Halbleitermaterial kann dann ein um 45° zu dieser aktiven Zone geneigter Spiegel koplanar z. B. zu einer Kristallebene mit den Miller-Indizes (101) ausgerichtet sein. Die bei kantenemittierenden Laserdioden übliche Ausrichtung des Laserresonators entspricht dem in Figur 1 eingezeichneten Balken 2, der in diesem Beispiel senkrecht auf der Kristallebene mit den Miller-Indizes (011) steht.

Eine typische Ausführungsform der Laserdiode ist in Figur 2 im Querschnitt gezeigt. Dargestellt ist ein Ende einer aktiven Schicht 2, die längs der aktiven Zone geschnitten gezeichnet ist. Unter dieser aktiven Schicht befindet sich eine erste Mantelschicht 1, die z. B. auf ein Substrat aufgewachsen ist oder durch den obersten Anteil eines Substrates aus III-V-Halbleitermaterial gegeben ist. Auf der dieser ersten Mantelschicht gegenüberliegenden Seite der aktiven Schicht befindet sich eine zweite Mantelschicht 3 und darauf ggf. eine für eine Kontaktierung mit einem Metallkontakt vorgesehene Kontaktschicht 4. Das Ende der aktiven Schicht ist in eine dritte Mantelschicht 5, die z. B. gesondert aufgewachsen ist, eingebettet. Die aktive Schicht endet mit ihrer Endfläche 7, die z. B. eine Spiegelendfläche sein kann, in dieser dritten Mantelschicht 5, die im Bereich der zu emittierenden Strahlung eine von der aktiven Schicht 2 abgewandte Grenzfläche 6 aufweist. Diese Grenzfläche 6 bildet zu den Schichtebenen einen Winkel von 45°, so daß bei diesem Ausführungsbeispiel die von der aktiven Zone emittierte Strahlung senkrecht nach unten durch das Substrat hindurch aus der Laserdiode ausgekoppelt wird. Die Endfläche 7 kann wie in diesem Beispiel geneigt oder senkrecht zur aktiven Schicht als Spiegelendfläche hergestellt sein. Als Materialien kommen bei dieser Laserdiode die für die entsprechenden Schichten üblicherweise vorgesehenen Materialien in Frage. Die dritte Mantelschicht 5 weist die erfindungsgemäß verwendete Ausrichtung der Zinkblendestruktur auf. Die Grenzfläche 6 wird also durch eine Kristallebene mit den Miller-Indizes (101) oder (10$\bar{1}$) oder entsprechend gebildet. Vorzugsweise sind auch das Substrat sowie zumindest die erste Mantelschicht 1 aus III-V-Halbleitermaterial mit Zinkblendestruktur gebildet, so daß bei nachträglichem Aufwachsen der dritten Mantelschicht 5 diese in der erforderlichen Kristallgitterstruktur und -ausrichtung aufwächst. Die Längsrichtung der aktiven Zone wird dann entsprechend der Kristallgitterstruktur bereits des Substrates bzw. der ersten Mantelschicht senkrecht zu einer Kristallebene mit den Miller-Indizes (100) oder (010) oder (001) ausgerichtet. Die Grenzfläche 6 kann z. B. mit einer reflektierenden Beschichtung, wie z. B. einer Schichtfolge von $Al_2O_3$ und Si versehen sein. Die Rückseite des Substrates kann an der für den Lichtaustritt vorgesehenen Stelle mit einer Antireflexschicht z. B. aus einer dünnen Schicht aus $Al_2O_3$ versehen sein.

Im Materialsystem von InP sind die erste Mantelschicht 1, die zweite Mantelschicht 3 und die dritte Mantelschicht 5 vorzugsweise InP. Die erste Mantelschicht 1 und die zweite Mantelschicht 3 sind für elektrische Leitung entgegengesetzter Vorzeichen dotiert. Die erste Mantelschicht 1 ist z. B. n-leitend dotiert und die zweite Mantelschicht 3 p-leitend. Für die aktive Schicht 2 kommt z. B. eine ternäre oder quaternäre Zusammensetzung oder eine MQW-Schichtfolge (Multiple Quantum Well) in Frage. Eine vorhandene Kontaktschicht 4 ist z. B. hoch für den Leitfähigkeitstyp der zweiten Mantelschicht 3 dotiertes InGaAs. Bei einer Ausführungsform im Materialsystem von GaAs werden entsprechend die für Laserdioden üblichen Schichtfolgen verwendet, wobei hier die dritte Mantelschicht 5 GaAs mit einer erfindungsgemäßen Ausrichtung der Zinkblendestruktur ist.

Die erfindungsgemäße Laserdiode wird vorzugsweise hergestellt, indem z. B. zunächst eine Schichtfolge aufgewachsen wird, die die erste Mantelschicht 1, die aktive Schicht 2, die zweite Mantelschicht 3 und vorzugsweise die Kontaktschicht 4 umfaßt. Z. B. mittels reaktiven Ionenätzens wird an einer Stelle der Schichtfolge von der überwachsenen Seite des Substrates her eine rechteckige Grube mit senkrechten Wänden oder mittels Ionenstrahlätzens eine pyramidenstumpfförmige Grube mit schrägen Wänden hergestellt. Die Wände dieser Grube bilden in jedem Fall mit der Schichtebene der aktiven Schicht einen Winkel, der größer als 45° und höchstens 90° ist. Die Grube wird z. B. in eine Tiefe von etwa 4 µm geätzt.

Danach erfolgt eine Epitaxie des für die dritte Mantelschicht 5 vorgesehenen III-V-Halbleitermateriales mit Zinkblendestruktur. Diese Schicht wird in einer Dicke von etwa 1 µm aufgewachsen. Danach kann das naßchemische Ätzen der als Spiegel vorgesehenen Grenzfläche 6 mit einer diesem Material der dritten Mantelschicht 5 entsprechenden Ätzlösung erfolgen. Bei InP kann z. B. mit Salzsäure (HCl in wäßriger Lösung) geätzt werden. Die Ätzgeschwindigkeit wird wie üblich über die Konzentration und die Temperatur des Ätzmittels eingestellt. Bei der vorzugsweisen Ausführungsform mit oberer Kontaktschicht 4 kann diese Kontaktschicht als Ätzmaske dienen. Das Ätzen wird beendet, wenn die Grenzfläche 6 im Winkel von 45° hergestellt ist. Da die Kontaktschicht 4 dabei nur langsam unterätzt wird, ist eine ausreichend große Sicherheit bei der Prozeßführung gegeben, so daß die aktive Schicht dabei nicht beschädigt wird und die dritte Mantelschicht 5 die Endfläche 7 der aktiven Schicht 2 einbettet. Das Unterätzen ist in der Figur 2 nicht dargestellt.

## Patentansprüche

1. Laserdiode in III-V-Halbleitermaterial mit Zinkblendestruktur,

   bei der eine für Strahlungserzeugung geeignete aktive Schicht (2) zwischen einer ersten Mantelschicht (1) aus Halbleitermaterial mit einer Dotierung für elektrische Leitung eines ersten Leitfahigkeitstyps und einer zweiten Mantelschicht (3) aus Halbleitermaterial mit einer Dotierung für elektrische Leitung des entgegengesetzten Leitfahigkeitstyps angeordnet ist,
   bei der diese aktive Schicht eine für Strahlungserzeugung vorgesehene streifenförmige aktive Zone aufweist,
   bei der diese aktive Schicht zumindest an einem Ende dieser aktiven Zone durch eine dritte Mantelschicht (5) aus III-V-Halbleitermaterial in der Längsrichtung der aktiven Zone begrenzt ist,
   bei der diese dritte Mantelschicht (5) eine von dieser aktiven Schicht abgewandte Grenzfläche (6) hat, und
   bei der diese Grenzfläche koplanar zu einer Ebene der Zinkblendestruktur des Halbleitermateriales dieser dritten Mantelschicht verläuft, die einer Kristallgitterebene mit Miller-Indizes (101) entspricht.

2.  Laserdiode nach Anspruch 1,

    bei der die erste Mantelschicht (1) aus III-V-Halbleitermaterial ist und bei der die aktive Zone so angeordnet ist, daß ihre Längsrichtung senkrecht zu einer Ebene der Zinkblendestruktur dieser ersten Mantelschicht verläuft, die einer Kristallgitterebene mit Miller-Indizes (001) entspricht.

3.  Laserdiode nach Anspruch 1 oder 2,

    bei der die aktive Zone mit der aktiven Schicht (2) an der dritten Mantelschicht (5) endet und bei der zwischen der aktiven Schicht und der dritten Mantelschicht eine für einen Laser-Resonator vorgesehene Spiegelendfläche (7) vorhanden ist.

4.  Laserdiode nach einem der Ansprüche 1 bis 3, bei der für eine Laser-Resonanz ein DBR-Gitter oder ein DFB-Gitter koplanar zu der aktiven Schicht (2) angeordnet vorhanden ist.

5.  Laserdiode nach einem der Ansprüche 1 bis 4, bei der die aktive Schicht (2) streifenförmig ausgebildet ist und die aktive Zone bildet.

## Claims

1.  Laser diode in III-V semiconductor material with zinc blende structure,

    in which an active layer (2), suitable for generating radiation, is arranged between a first cover layer (1) made of semiconductor material with doping for electrical conduction of a first conductivity type and a second cover layer (3) made of semiconductor material with doping for electrical conduction of the opposite conductivity type,
    in which this active layer has a strip-like active region intended for generating radiation,
    in which this active layer is bounded in the longitudinal direction of the active region, at least at one end of this active region, by a third cover layer (5) made of III-V semiconductor material,
    in which this third cover layer (5) has a boundary face (6) on the opposite side from this active layer, and
    in which this boundary face extends coplanar with a plane, corresponding to a crystal lattice plane with Miller index (101), of the zinc blende structure of the semiconductor material of this third cover layer.

2.  Laser diode according to Claim 1,

    in which the first cover layer (1) is made of III-V semiconductor material, and
    in which the active region is arranged in such a way that its longitudinal direction extends perpendicular to a plane, corresponding to a crystal lattice plane with Miller index (001), of the zinc blende structure of this first cover layer.

3.  Laser diode according to Claim 1 or 2, in which the active region ends with the active layer (2) at the third cover layer (5), and in which, between the active layer and the third cover layer, there is a mirror end face (7) provided for a laser resonator.

4.  Laser diode according to one of Claims 1 to 3, in which, for a laser resonance, there is a DBR grating or a DFB grating arranged coplanar with the active layer (2).

5.  Laser diode according to one of Claims 1 to 4, in which the active layer (2) has a strip-like design and forms the active region.

## Revendications

1.  Diode laser en matériau semi-conducteur III-V avec structure de la blende,

    pour laquelle une couche active (2) appropriée pour la production d'un rayonnement est disposée entre une première couche enveloppe (1) en matériau semi-conducteur avec un dopage pour la conduction électrique d'un premier type de conductibilité et une deuxième couche enveloppe (3) en matériau semi-conducteur avec un dopage pour la conduction électrique du type de conductibilité de signe opposé,
    pour laquelle cette couche active présente une zone active en forme de bande prévue pour la production d'un rayonnement,
    pour laquelle cette couche active est limitée dans la direction longitudinale de la zone active au moins à une extrémité de cette zone active par l'intermédiaire d'une troisième couche enveloppe (5) en matériau semi-conducteur III-V,
    pour laquelle cette troisième couche enveloppe (5) possède une interface (6) opposée à cette couche active, et
    pour laquelle cette interface s'étend de façon coplanaire par rapport à un plan de la structure de la blende du matériau semi-conducteur de cette troisième couche enveloppe, qui correspond à un plan de réseau cristallin avec l'indice de Miller (101).

2. Diode laser selon la revendication 1,

pour laquelle la première couche enveloppe (1) est en matériau semiconducteur III-V et pour laquelle la zone active est disposée de telle sorte que sa direction longitudinale s'étend de façon perpendiculaire par rapport à un plan de la structure de la blende de cette première couche enveloppe, qui correspond à un plan de réseau cristallin avec l'indice de Miller (001).

3. Diode laser selon la revendication 1 ou 2,

pour laquelle la zone active se termine au niveau de la troisième couche enveloppe (5) par la couche active (2) et pour laquelle est présente entre la couche active et la troisième couche enveloppe une surface extrême de miroir (7) prévue pour le résonateur laser.

4. Diode laser selon l'une des revendications 1 à 3, pour laquelle est présent pour une résonance laser, un réseau DBR ou un réseau DFB disposé de façon coplanaire par rapport à la couche active (2).

5. Diode laser selon l'une des revendications 1 à 4, pour laquelle la couche active (2) est formée en forme de bande et forme la zone active.

# FIG 1

# FIG 2